# EUROPEAN PATENT APPLICATION

(11) **EP 2 400 537 A2**
(43) Date of publication of application: **28.12.2011**
(21) Application number: 11169937.7
(22) Date of filing: 15.06.2011
(51) Int. Cl.: H01L 21/687

(54) **Susceptor for plasma processing chamber**

(30) Priority: 25.06.2010 US 358627 P
(71) Applicant: Orbotech LT Solar, LLC, San Jose, California 95119 (US)
(72) Inventor: Law, Kam S., San Jose, CA 95138 (US); Mao, Daisheng, Santa Clara, CA 95051 (US); Law, Robin K.F., Yuen Long (CN); Renta, Michael Allen, Campbell, CA 95008 (US)
(74) Representative: Kirschner, Klaus Dieter

(57) **Abstract**

A susceptor for a plasma process apparatus, the susceptor having a graphite main body with a top surface for supporting at least one substrate, the top surface having a plasma sprayed aluminum oxide coating. A vacuum processing chamber, has a main chamber body, a showerhead provided at the ceiling of the chamber body, a pedestal provided inside the chamber body, and a susceptor coupled to the pedestal, the susceptor is made of a graphite main body having a top surface for supporting at least one substrate, the top surface having a dielectric coating such as, e.g., plasma sprayed aluminum oxide coating.

## Description

This application claims priority benefit from U.S. Provisional Application Serial Number 61/358,627, filed on June 25, 2011, the content of which is incorporated herein by reference in its entirety.

The subject application relates to vacuum processing chambers, such as chambers used for chemical vapor deposition (CVD), plasma enhanced CVD (PECVD), physical vapor deposition (PVD), etc. The subject invention relates specifically to susceptors used for supporting the substrates inside the processing chambers.

Vacuum processing chambers, such as plasma processing chambers, e.g., PECVD, utilize RF power to ignite and sustain plasma. The RF power is applied to the chamber via electrodes, antenna, etc. In some chamber designs, the susceptor is used as one of the electrodes, in addition to its function to support the substrates during the plasma processing. In most of today's designs, the susceptor is temperature controlled. The nature of the susceptor requires that it is electrically conductive and thermally stable at the processing temperature. Therefore, one of the possible materials is graphite. However, use of graphite poses some problems in terms of plasma stability and film thickness non-uniformity. Additionally, the susceptor is susceptible to being etched during the chamber cleaning process, which normally utilizes plasma ignition without substrates placed on the susceptor, i.e., the susceptor is exposed to the plasma.

The following summary of the disclosure is intended to provide a basic understanding of some aspects and features of the invention. This summary is not an extensive overview of the invention and as such it is not intended to particularly identify key or critical elements of the invention or to delineate the scope of the invention. Its sole purpose is to present some concepts of the invention in a simplified form as a prelude to the more detailed description that is presented below.

Embodiments of the subject invention improve on the susceptor design and provide susceptors that enable maintaining stable plasma and depositing uniform films. Some examples disclosed herein relate to plasma processing chambers for fabrication of solar cells. Specifically, for the ARC (anti-reflective coating) application in solar cell fabrications, it was observed that the processing window is narrow in terms of desirable device characteristics if graphite susceptor is used as the ground electrode. Therefore, according to embodiments of the invention, a thin dielectric coating is formed on the graphite susceptor. In some examples the dielectric coating is a plasma sprayed aluminum oxide of a thickness of at least 3 microns and in some examples is about 50 microns. In other examples the dielectric coating is silicon nitride. Using such a coated susceptor, the plasma stability, film thickness non-uniformity and the saturation current density of the emitters are substantially improved.

The accompanying drawings, which are incorporated in and constitute a part of this specification, exemplify the embodiments of the present invention and, together with the description, serve to explain and illustrate principles of the invention. The drawings are intended to illustrate major features of the exemplary embodiments in a diagrammatic manner. The drawings are not intended to depict every feature of actual embodiments nor relative dimensions of the depicted elements, and are not drawn to scale.

Further advantages, features and potential applications of the present invention may be gathered from the description which follows, in conjunction with the embodiments illustrated in the drawings.

Throughout the description, the claims and the drawings, those terms and associated reference signs will be used as are notable from the enclosed list of reference signs. In the drawings
- Fig. 1A: is a schematic illustrating major elements of a PECVD process chamber including a graphite susceptor according to an embodiment of the invention;
- Fig. 1B: illustrates a design of a susceptor according to an embodiment of the invention;
- Fig. 2A: illustrates the film non-uniformity results of silicon nitride deposited on polysilicon wafers using a prior art susceptor, while Figure 2B illustrates the film uniformity results of silicon nitride deposited on polysilicon wafers using a graphite susceptor according to an embodiment of the invention, and
- Fig. 2B: illustrates the film uniformity results of silicon nitride deposited on polysilicon wafers using graphite susceptors with plasma sprayed coatings, according to an embodiment of the invention.

According to embodiments of the invention, the problems relating to the prior art susceptor as mentioned above are resolved by providing a dielectric coating on the top surface of the susceptor. According to one example, the dielectric coating is plasma sprayed aluminum oxide of a thickness of at least 3 microns. According to one example, the thickness is about 50 microns. The plasma stability, film thickness non-uniformity and the saturation current density of the emitters are substantially improved using such a susceptor.

Silicon nitride is another dielectric that can be used as a coating. The dielectric constant of silicon nitride (6-8) is somewhat similar to aluminum oxide (about 9); however, in practice plasma sprayed aluminum oxide is easier to manufacture. Therefore, the examples provided below relate to plasma sprayed aluminum oxide.

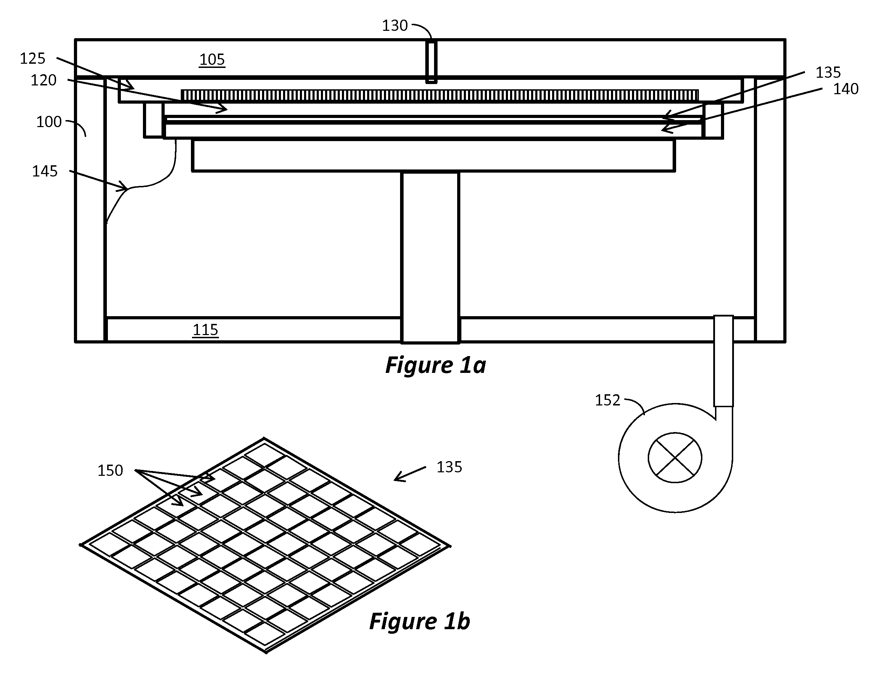

Fig. 1A is a schematic illustrating major specifications of PECVD process chamber, including the graphite susceptor. The body 100, ceiling 105 and floor 115 form an chamber having processing space 120, which is evacuated by pump 152. A showerhead 125 receives gases via conduit 130 and introduces the gases into the space 120. The susceptor 135 is supported by pedestal 140, which may include a heater. The pedestal 140 may or may not be movable in elevation. A grounding strap 145 couples the susceptor to ground potential if the RF power source is coupled to an electrode in the ceiling or the showerhead.

Fig. 1B illustrates in more details a design of the susceptor 135 according to an embodiment of the invention. The susceptor 135 of this example is used for processing a plurality of substrate, e.g., for fabricating solar cells. The substrates (not shown) are housed in the pockets 150 formed on the top surface of the graphite susceptor 135. The top surface is coated with a dielectric, such as aluminum oxide.

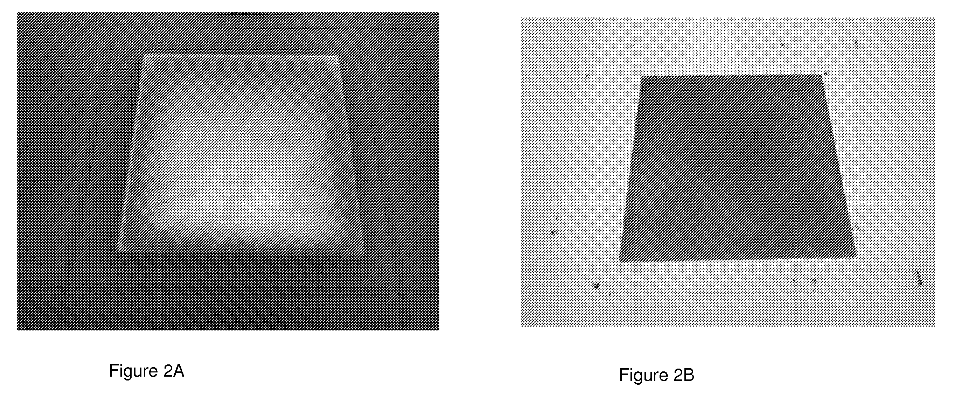

Fig. 2A illustrates the film non-uniformity results of silicon nitride deposited on polysilicon wafers using graphite susceptors according to the prior art. As can be seen, the deposition is thinner towards the edge of the substrate, and in fact, almost no deposition is seen at the very edge of the wafer. Such a result is unacceptable, as in this example the nitride layer serves as an insulating protector and as an anti-reflection layer, so that light entering the solar cell is converted to electricity, rather than reflected. With such a non-uniform deposition, efficiency of the solar cell will be reduced since at the edges the light will be reflected and not fully utilized for photoelectric conversion.

Fig. 2B illustrates the film uniformity results of silicon nitride deposited on polysilicon wafers using graphite susceptors with plasma sprayed coatings, according to an embodiment of the invention. As can be seen by the uniform blue color over the entire surface of the wafer, the silicon nitride deposition is significantly more uniform using the coated susceptor.

A 5" n-type c-Si solar cell wafer was selected as monitor wafer. Prior to depositing the anti-reflection layer, the wafer has been processed with double sided surface texture, double sided p-type doping and double sided SiO₂ coating. During the anti-reflection layer deposition step, around 800A SiN film is deposited on both sides of wafer, resulting in deep blue color. After double sided silicon nitride deposition, the monitor wafer is measured with Sinton WCT-120 photoconductance lifetime tester. The illumination mode is setup as transient (flash setting 1/64). The total saturation current density of emitters (Jₒ) is indicated from PCID simulation software. The monitor has double sided emitters. So the single side saturation current density of emitter is half of the total Jₒ from PCID. The monitor wafers were processed with several conditions on graphite susceptors with and without coating. The single side saturation current densities of the emitter are compared in the table 1. The decreasing of Jₒ increases open circuit Voltage (Voc) and solar cell efficiency.

Table1 illustrate the saturation current density of emitters comparison of TTW (textured test wafer) on susceptor with and without coatings after double sided silicon nitride deposition.

**Table 1: The comparison of saturation current density of emitters of textured test wafers**

| Susceptor | Graphite without coating | Graphite with aluminum oxide coating |
|---|---|---|
| Jo(fA/cm2) | 58 | 15 |
| condition 1: low N2 flow and high pressure | | |
| Jo(fA/cm2) | 66 | 13 |
| condition 2: high N2 flow and low pressure | | |
| Jo(fA/cm2) | 86 | 16 |
| condition 3: small electrode spacing | | |

As can be seen form Table 1, the wafers processed on a susceptor according to embodiments of the invention provide a much improved Jₒ. In this example the susceptor was coated by plasma spray of aluminum oxide of thickness about 50 microns.

The present invention has been described in relation to particular examples, which are intended in all respects to be illustrative rather than restrictive. Those skilled in the art will appreciate that many different combinations of hardware, software, and firmware will be suitable for practicing the present invention. Moreover, other implementations of the invention will be apparent to those skilled in the art from consideration of the specification and practice of the invention disclosed herein. Various aspects and/or components of the described embodiments may be used singly or in any combination in the plasma chamber arts. It is intended that the specification and examples be considered as exemplary only, with a true scope and spirit of the invention being indicated by the following claims.

### List of reference signs

- 100: body
- 105: ceiling
- 115: floor
- 120: space
- 125: showerhead
- 130: conduit
- 135: susceptor
- 140: pedestal
- 145: strap
- 150: pocket
- 152: pump

## Claims

1. A susceptor for a plasma process apparatus, comprising a graphite main body having a top surface for supporting at least one substrate, the top surface having a dielectric coating formed thereupon.

2. The susceptor of claim 1, comprising a graphite main body having a top surface for supporting a plurality of substrates, the top surface having a plurality of pockets for housing the substrates.

3. The susceptor of claim1 or 2, wherein the dielectric coating comprises a plasma sprayed aluminum oxide coating.

4. The susceptor of claim 1 or 2, wherein the coating is of thickness of at least 3 micron.

5. The susceptor of claim 1 or 2, wherein the coating is of thickness of about 50 micron.

6. The susceptor of claim 1 or 2, wherein the dielectric coating comprises silicon nitride.

7. A vacuum processing chamber, comprising:
a main chamber body;
a showerhead provided at a ceiling of the chamber body;
a pedestal provided inside the chamber body; and
a susceptor according to any of the preceding claims coupled to the pedestal.
